# DEMANDE DE BREVET EUROPEEN

(11) **EP 0 907 239 A1**
(43) Date de publication de la demande: **07.04.1999**
(21) Numéro de dépôt: 98402081.8
(22) Date de dépôt: 20.08.1998
(51) Int. Cl.: H03G 3/30

(54) **Emetteur pour terminal radiotéléphonique et terminal correspondant**

(30) Priorité: 02.10.1997 FR 9712261
(71) Demandeur: ALCATEL, 75008 Paris (FR)
(72) Inventeur: Greverie, Franck, 75002 Paris (FR); Sarrazin, Emile, 95350 St Brice Sur Foret (FR)
(74) Mandataire: Fournier, Michel Robert Marie

(57) **Abrégé**

L'invention propose un émetteur (1), notamment pour terminal radiotéléphonique portable d'usager, dont la sortie comporte un amplificateur (10) et des moyens (13. 15, 16, 17) permettant de commander le niveau de puissance de sortie de cet amplificateur.

L'émetteur comporte en supplément des moyens (6, 7, 8, 9) permettant de contrôler le niveau de puissance du signal d'entrée radiofréquence fourni audit amplificateur pour pouvoir en positionner le point de fonctionnement près ou au niveau de la limite entre zone de fonctionnement linéaire et zone de fonctionnement en saturation.

## Description

L'invention concerne un émetteur radio et plus particulièrement un émetteur pour terminal radiotéléphonique portable d'usager.

Un des problèmes que pose le développement des communications par voie radiotéléphonique entre terminaux portables par l'intermédiaire d'au moins une station d'un réseau radiomobile, tel qu'un réseau GSM-DCS-PCS, est d'assurer un strict respect des normes imposées aux terminaux en matière d'émission pour éviter que des terminaux ne produisent des émissions parasites à des fréquences supérieures à celles prévues pour leurs émissions et en particulier des émissions parasites en bande de réception. En effet, vu le nombre de terminaux commercialisés, les conséquences de telles émissions parasites pourraient avoir des effets particulièrement négatifs sur la qualité des communications établies.

Les moyens techniques actuels permettent de réaliser un filtrage efficace de canal qui évite l'émission de signaux parasites, lorsqu'un émetteur incorpore un mélangeur à fréquence intermédiaire et même si cet émetteur comporte un amplificateur de puissance insuffisamment linéaire, le filtrage étant alors préférablement réalisé en sortie du mélangeur à fréquence intermédiaire.

Toutefois, la mise en oeuvre de ces moyens a un coût que les fabricants de terminaux s'efforcent de réduire. En particulier, il est réalisé des émetteurs à fréquence intermédiaire nulle où les possibilités de filtrage de canal se trouvent en bande de base et donc très en amont de l'amplificateur de puissance et de l'antenne que cet amplificateur alimente.

Le document FR-A-2726410 décrit un émetteur de terminal mobile dont l'amplificateur de puissance, chargé d'amplifier les signaux haute fréquence de communication à émettre, est doté d'une boucle de commande permettant de faire opérer cet amplificateur aussi près que possible de la saturation pour améliorer son efficacité. Toutefois cette solution ne résout pas totalement le problème évoqué plus haut dans la mesure où, suivant le niveau de puissance du signal d'entrée appliqué à l'amplificateur de puissance, le point réel de fonctionnement de cet amplificateur peut dévier du point de fonctionnement imposé par la boucle et entraîner un fonctionnement de l'émetteur qui ne soit pas admissible.

L'invention propose donc un émetteur pour terminal radiotéléphonique et notamment pour terminal portable d'usager.

Cet émetteur dispose d'un amplificateur de puissance situé à sa sortie et de moyens permettant de commander cet amplificateur de manière à lui imposer un point de fonctionnement près ou au niveau de la limite entre zone de fonctionnement linéaire et zone de fonctionnement en saturation.

Pour pouvoir positionner et fixer le point de fonctionnement de l'amplificateur aussi près que possible de la saturation, l'émetteur comporte des moyens pour contrôler le niveau de puissance du signal d'entrée radiofréquence fourni audit amplificateur.

L'invention, ses caractéristiques et ses avantages sont précisés dans la description qui suit en liaison avec les figures évoquées ci-dessous.

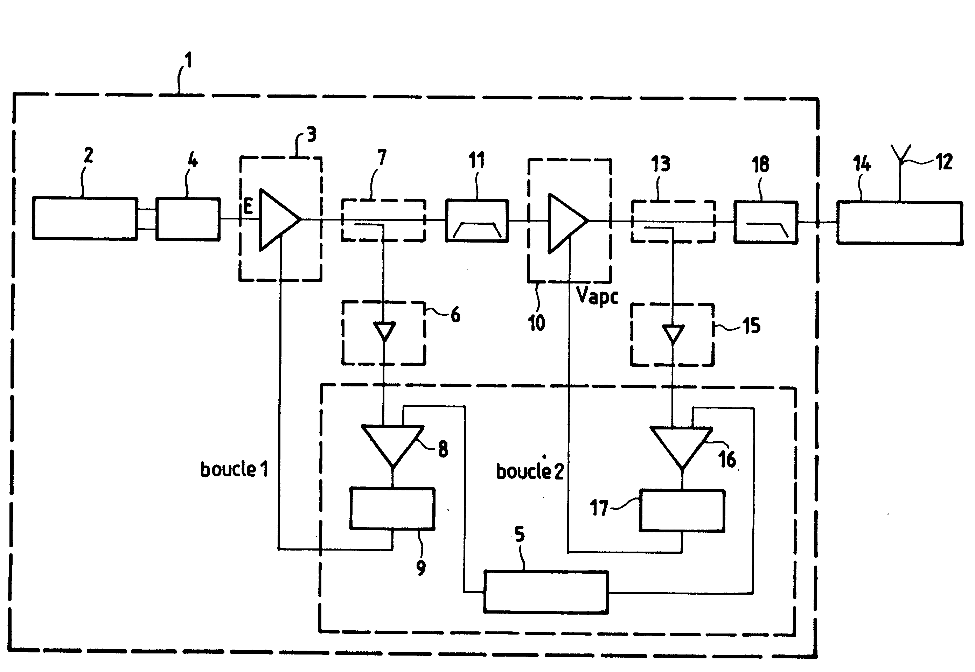

La figure unique 1 présente un schéma d'un émetteur pour terminal radiotéléphonique mobile.

L'émetteur 1 schématisé sur la figure unique est destiné à équiper un terminal radiotéléphonique et plus particulièrement un terminal portable d'usager pour réseau radiomobile, par exemple un terminal portable de l'un ou l'autre des systèmes de radiocommunications désignés par les acronymes anglais GSM, DCS ou PCS.

Comme indiqué ci-dessus, cet émetteur 1 est conçu pour éviter le plus possible la génération de signaux parasites à des fréquences supérieures à celles prévues pour les émissions des terminaux d'usager. Il permet en conséquence de réduire le filtrage avant émission qui est usuellement indispensable pour éviter qu'un émetteur ne génère des signaux parasites gênants.

Les émissions provenant des usagers des réseaux radiomobiles sont constituées, d'une part, par des signaux de communication proprement dits qui sont numérisés dans les réseaux radiomobiles évoqués ci-dessus et qui correspondent aux signaux, notamment vocaux, que l'usager désire transmettre vers un autre usager par l'intermédiaire d'un terminal radiomobile dont il a l'usage et, d'autre part, par les signalisations qui peuvent ou doivent accompagner ces signaux de communication.

Ces derniers sont fournis à un circuit d'entrée 2, le plus généralement de type mélangeur comme supposé ici, qui leur permet d'être associés sous forme de modulation à un signal radiofréquence porteur de fréquence déterminée de manière à constituer un signal dit d'entrée de chaîne d'émission.

Le signal modulé obtenu est transmis à une entrée de signal E d'un préamplificateur 3, par l'intermédiaire d'un transformateur d'adaptation 4, qui, comme il est connu de l'homme de métier, est le plus souvent du type désigné par l'acronyme anglais "BALUN".

Il est prévu de contrôler dynamiquement la puissance de sortie du préamplificateur 3 qui reçoit le signal d'entrée tel que défini ci-dessus. L'entrée de commande de ce préamplificateur est en conséquence incluse dans une boucle de commande prenant en compte le niveau de puissance du signal que fournit le préamplificateur 3 et une indication fournie par un générateur de références 5. Le niveau du signal apparaissant en sortie du préamplificateur 3 est classiquement pris en compte par l'intermédiaire d'un détecteur d'enveloppe 6 relié en sortie du préamplificateur par un coupleur directionnel 7. Le détecteur d'enveloppe 6 est par exemple un détecteur à base de diodes SCHOTTKY et le coupleur directionnel 7 est par exemple un composant céramique ou un simple coupleur capacitif.

Le niveau de puissance du signal obtenu en sortie du détecteur 6 est pris en compte avec une valeur de référence fournie par le générateur de références 5, sous le contrôle d'une logique non représentée ici du terminal. Cette logique est éventuellement une logique de type câblée ou encore un processeur dûment programmé que comporte le terminal, cette logique n'étant pas représentée sur la figure unique où ne sont figurés que l'émetteur 1, un commutateur d'antenne et une antenne. La prise en compte s'effectue par l'intermédiaire de moyens matériels et/ou logiciels, ici symbolisés par un comparateur 8 recevant d'une part le signal fourni par le détecteur 6 et d'autre part la référence émanant du générateur de références 5. Le signal obtenu à l'aide des moyens symbolisés par le comparateur 8 est appliqué à un circuit de contrôle de gain 9 qui pilote le préamplificateur 3. Ceci permet d'une manière connue de l'homme de métier de fixer le point de fonctionnement de cet amplificateur et plus particulièrement le niveau de puissance du signal de sortie qu'il produit à partir du signal d'entrée qu'il reçoit.

Le signal de sortie du préamplificateur 3 est appliqué à une entrée de signal El d'un amplificateur de puissance 10 en sortie d'émetteur 1, par l'intermédiaire d'un filtre 11, de type passe-bande.

La boucle de commande constituée autour du préamplificateur 3 à l'aide du coupleur 7, du détecteur 6, du comparateur 8 et du circuit de contrôle de gain 9 permet d'appliquer une puissance constante à l'entrée de l'amplificateur de puissance 10 quelles que soient la fréquence d'émission dans la bande passante de l'émetteur, la température et la dispersion entre lots de composants pour ceux de ces composants qui sont montés en amont de l'amplificateur de puissance.

Chaque terminal est susceptible d'avoir son émetteur réglé, soit automatiquement en production, soit manuellement en laboratoire, de façon que le niveau de puissance en entrée d'amplificateur de puissance soit toujours la même. Il est d'ailleurs possible d'optimiser la puissance nécessaire en entrée d'amplificateur de puissance en réglant spécifiquement le niveau pour chaque poids de puissance, les différents poids correspondants à des tensions de commande Vapc différentes.

L'amplificateur de puissance 10 est dynamiquement contrôlé par l'intermédiaire d'une boucle de commande qui agit sur l'entrée de commande Vapc de cet amplificateur, cette entrée pouvant être la grille et/ou le drain de puissance. Cette boucle prend en compte le niveau de puissance du signal apparaissant en sortie d'amplificateur pour être transmis à une antenne d'émission 12. Un coupleur 13, correspondant au coupleur 7, est inséré sur le trajet entre la sortie de l'amplificateur de puissance 10 et un commutateur d'antenne 14 par l'intermédiaire de laquelle l'antenne 12 est alimentée en phase d'émission.

Un filtre 18, de type passe-bas ou coupe-bande, permettant d'éliminer les émissions parasites correspondant aux harmoniques du signal à transmettre est inséré en sortie de l'amplificateur de puissance 10, en amont du commutateur d'antenne 14 et en aval du coupleur 13 dans l'exemple présenté.

Un détecteur 15, correspondant au détecteur 6, permet la détermination du niveau de puissance du signal apparaissant en sortie de l'amplificateur de puissance 10 et une prise en compte de ce signal par des moyens symbolisés ici par un comparateur 16, ces moyens correspondant fonctionnellement aux moyens symbolisés par le comparateur 8. Le signal obtenu en sortie des moyens symbolisés par le comparateur 16, à partir du niveau de puissance déterminé par l'intermédiaire du détecteur 15 et d'une valeur de référence fournie par le générateur de références 5, est appliqué à une circuit de contrôle de gain, dit d'alimentation 17, qui agit sur l'entrée de commande Vapc de l'amplificateur de puissance 10, d'une manière analogue à celle évoquée plus haut en liaison avec le préamplificateur 3.

Ce préamplificateur 3 permet de contrôler le niveau du signal fourni en entrée de l'amplificateur de puissance 10 et donc d'assurer une constance de niveau de signal à cette entrée, ce qui favorise un fonctionnement correct de cet amplificateur de puissance, sans déviation par rapport au point de fonctionnement fixé pour lui par le circuit de contrôle de gain d'alimentation 17, en particulier lorsque cet amplificateur fonctionne au niveau de la limite entre zones de fonctionnement linéaire et zone de fonctionnement en saturation, comme recherché.

Un fonctionnement au point de compression à 1db qui est optimisé au point de vue des performances, avec un compromis efficacité - non linéarité acceptable, et cela quelles que soient les conditions environnantes et quel que soit le niveau de la tension de commande Vapc.

La combinaison des boucles de commande incluant respectivement les circuits de contrôle de gain 9 et 17 permet d'obtenir une grande précision de positionnement du point de fonctionnement de l'amplificateur de puissance 10. Elle permet aussi de réduire le filtrage dans la chaîne d'émission et notamment de celui assuré par les filtres 11 et 18. Dans un système classique, sans contrôle précis du point de fonctionnement de l'amplificateur de puissance, le filtre 18 atténue les émissions parasites en bande de réception et les harmoniques de l'amplificateur de puissance.

Comme la bande de réception est prévue très proche de la bande d'émission avec par exemple 10 ou 20 MHz d'interbande, le filtre 18 doit être important ce qui a pour conséquence d'accroître les pertes d'insertion en aval de l'amplificateur de puissance 10. Lorsque le point de fonctionnement de l'amplificateur n'est pas déterminé avec précision, il est indispensable d'appliquer une puissance d'entrée à cet amplificateur qui soit plus importante que celle qui serait normalement nécessaire dans les conditions nominales afin d'assurer un fonctionnement correct même dans des conditions défavorables. Le surplus de puissance d'entrée a pour effet d'augmenter les émissions parasites en bande de réception lorsque les conditions de fonctionnement sont nominales et donc d'impliquer un durcissement du filtrage réalisé par le filtre 18.

L'accroissement de précision obtenu grâce à l'invention permet donc un relâchement des exigences au niveau des filtres 11 et 18.

Cette combinaison de circuits de contrôle est aussi particulièrement intéressante, lorsqu'il n'y a pas de duplexeur pour relier l'émetteur 1 à l'antenne d'émission 12, comme envisagé dans l'exemple proposé ici. En effet, il est alors possible de réduire en conséquence la consommation de l'émetteur et la puissance en sortie de l'amplificateur de puissance 10 de cet émetteur.

## Revendications

1. Emetteur (1), notamment pour terminal radiotéléphonique, incluant en sortie un amplificateur de puissance (10) et des moyens (13, 15, 16, 17) permettant de commander cet amplificateur de manière à lui imposer un point de fonctionnement près ou au niveau de la limite entre zone de fonctionnement linéaire et zone de fonctionnement en saturation, caractérisé en ce qu'il comporte des moyens (6, 7, 8, 9) pour contrôler le niveau de puissance du signal d'entrée radiofréquence fourni audit amplificateur, pour pouvoir en positionner ledit point de fonctionnement.

2. Emetteur, selon la revendication 1, dans lequel les moyens permettant de contrôler le niveau de puissance du signal d'entrée radiofréquence fourni à l'amplificateur de puissance (10) situé en sortie d'émetteur, sont constitués par une boucle de contrôle de gain dotée de moyens (6) pour mesurer le niveau de puissance du signal radiofréquence destiné à être fourni audit amplificateur, de moyens de contrôle de gain (9) agissant sur un préamplificateur (3) placé en amont de l'entrée de signal radiofréquence de l'amplificateur de puissance, et de moyens de prise en compte (8) agissant sur les moyens de contrôle de gain en fonction des indications qu'ils reçoivent respectivement des moyens de mesure de niveau de puissance et de moyens (5) fournisseurs de référence(s).

3. Terminal radio téléphonique d'usager, caractérisé en ce qu'il comporte un émetteur selon l'une des revendications précédentes de manière à fonctionner près ou au niveau de la limite entre zone de fonctionnement linéaire et zone de fonctionnement en saturation avec un minimum d'émissions parasites.
